Europäisches Patentamt

**European Patent Office**

**Office européen des brevets**

(19)

(11) Publication number: **0 162 521**
**A2**

# (12) EUROPEAN PATENT APPLICATION

(21) Application number: **85200770.7**

(22) Date of filing: **14.05.85**

(51) Int. Cl.⁴: **H 01 L 23/04**
**H 01 L 23/48**

(30) Priority: **23.05.84 US 613657**

(43) Date of publication of application:
**27.11.85 Bulletin 85/48**

(84) Designated Contracting States:
**DE FR GB NL SE**

(71) Applicant: **AMERICAN MICROSYSTEMS,
INCORPORATED
3800 Homestead Road
Santa Clara, CA 95051(US)**

(72) Inventor: **Cooley, Richard F.
876 Dry Creek Road
Campbell California 95008(US)**

(74) Representative: **Noz, Franciscus Xaverius, Ir. et al,
Boschdijk 155 P.O. Box 645
NL-5600 AP Eindhoven(NL)**

(54) **Package for semiconductor devices.**

(57) A programmable package for integrated circuits includes a ground plane, a power plane and a plurality of electrically isolated but conductive fingers and a multiplicity of terminals on the exterior of the package. A selected number of fingers handling selected I/O signals are connected directly to the multiplicity of terminals on the package exterior. Additional fingers are available within the package connected to a ground plane or to a power plane or to an I/O plane. The result is a package in which the particular terminals connected to external power and ground and handling I/O signals can be programmed in accordance with the needs of the circuit and the arrangement of the bonding pads on the die.

FIGURE 1

Croydon Printing Company Ltd.

TITLE MODIFIED
-1-    see front page

## PROGRAMMABLE PACKAGE

### BACKGROUND OF THE INVENTION

#### Field of the Invention

This invention relates to the packaging of semiconductor devices and in particular to a package which is capable of being used with a variety of integrated circuit chips.

#### Background of the Invention

Packages for semiconductor integrated circuits have become more complex in recent years due to the need to provide a larger number of terminals on the package to interconnect the integrated circuit in the package with the external circuitry with which it is to work. Each package also requires a ground pin and a power supply pin (commonly denoted $V_{DD}$ for the most positive power supply and/or $V_{SS}$ for the most negative power supply). One problem in integrated circuits is that noise in the power supply to the circuit is transmitted into the integrated circuit and causes errors in the performance of the circuitry. Typically the switching on and off of signals on the I/O pins will cause noise on the $V_{DD}$ supply, which causes fluctuations in the power supplied to the chip, interfering with the function of the circuit. This is undesirable. Accordingly, it is desirable to provide in the package, if possible, a filter for such noise. Commonly a chip capacitor is added external to the package to filter such noise.

As the number of terminals required of packages has increased, so-called "pin grid array" packages have been developed containing up to several hundred I/O, power and ground terminals arranged in a square or rectangular array. Such packages are often symmetrical in appearance and thus are capable of being plugged into a socket in any one of four ways. Typically, however, only one way is correct for mounting the package. One technique that has been employed to prevent destruction of microelectronic components due to erroneous mounting of symmetrical packages at the time of electrical test has been to place multiple $V_{DD}$ and $V_{SS}$ terminals in symmetrical locations on the package. These terminals will prevent incorrect application of power to the device thereby preventing the device from being destroyed. This technique also provides power and ground supplies around the chip at various locations within the package. This is an advantage in minimizing the amount of semiconductor surface area required for on-chip power and ground buses. While the technique prevents electrical damage to the device due to incorrect application of power supply voltages at test and in end use applications, it requires the dedication of a number of package terminals to power and ground. This reduces the number of terminals available for signal I/O use. Thus a larger package is necessary to accommodate the additional terminals required.

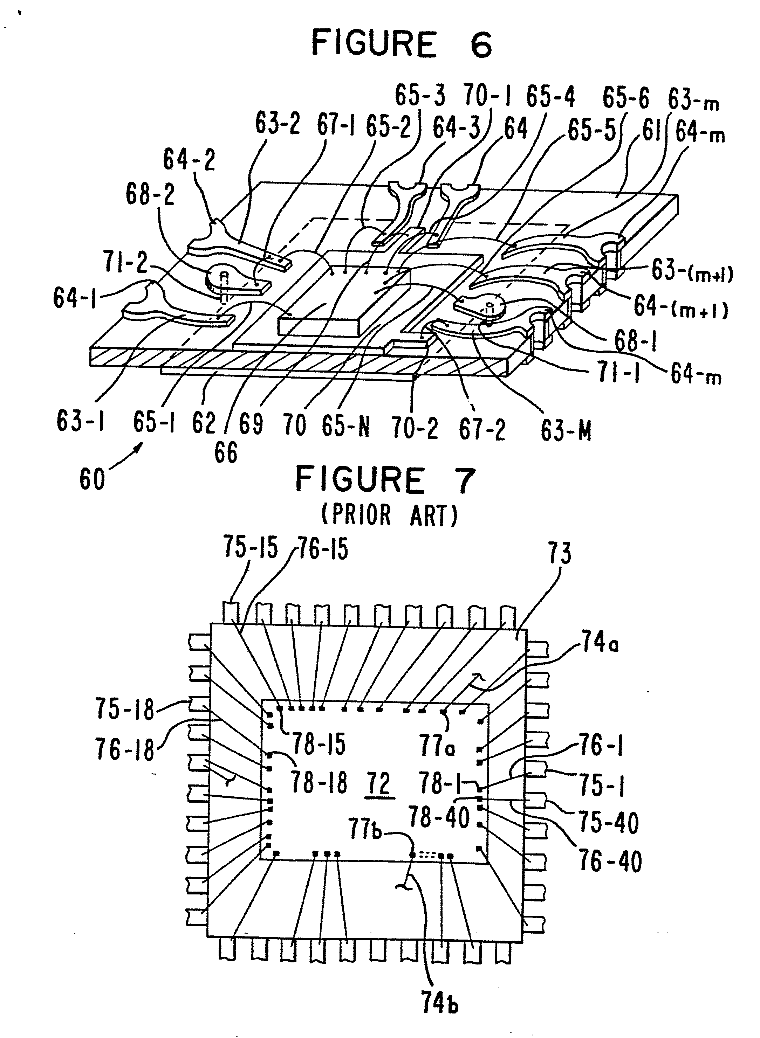

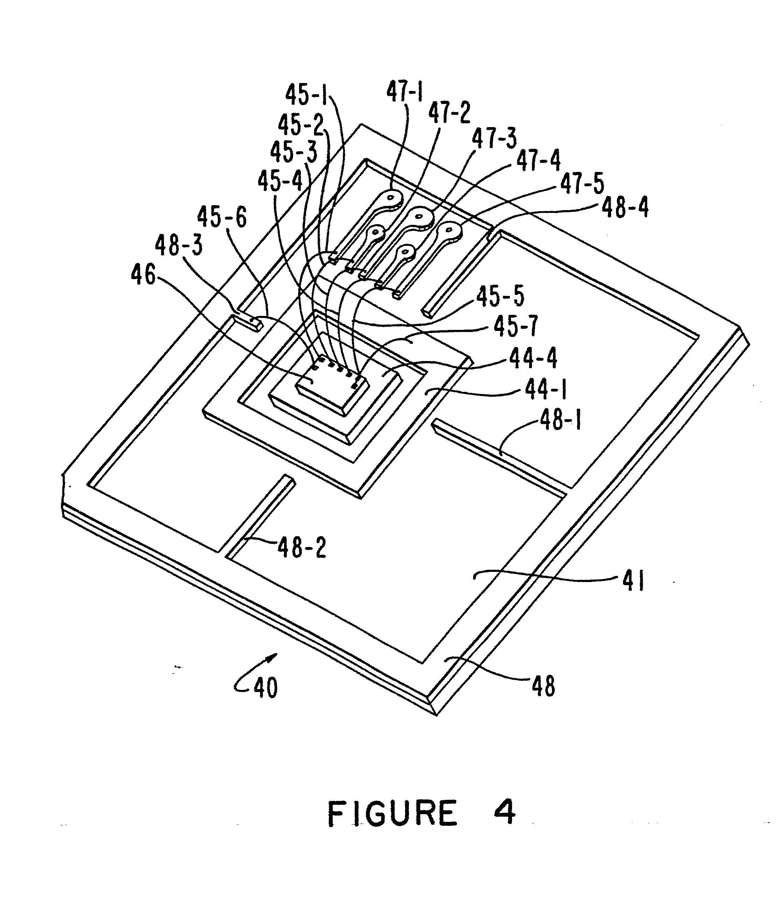

In the prior art a semiconductor die has been mounted on a ground plane wherein portions of the ground plane extend beyond the semiconductor die. Figure 7 illustrates this structure. A number of lead bonds 74a, 74b are connected from ground pads 77a, 77b on the die 72 to the extensions of the ground plane 73 around the periphery of the die. Such ground plane extensions allow easy access to be made from bonding pads on the die to the ground plane wherever it is convenient to do so. A plurality of fingers or bonding pads (shown as 75-1 through 75-40) are then provided in the package on either the same level or another level to allow input/output terminals to be interconnected with the die 72 from external circuitry by means of bonding wires 76-1 through 76-40 connected from each finger 75-1 through 75-40 to a correponding pad 78-1 through 78-40 on the die 72.

Techniques for avoiding the erroneous mounting of a package in the board or socket include the use of one or more asymmetric leads from the package to prevent the package from being mounted in any but the correct way. This, however, creates added expense and is sometimes undesirable in that an attempt to place the packaged part erroneously in its socket can deform or ruin some of these leads thereby destroying the package. Furthermore, if the entire surface of the package contains I/O pins there may be no room for an asymmetrically mounted pin.

Prior art packages have not been totally effective in overcoming the above problems.

## Summary of the Invention

This invention overcomes many of the above cited disadvantages of prior art integrated circuit packages and provides a package which is capable of allowing flexibility in the assignment of the functions to the terminals (often called "pins") of the package. Such terminals are available on the outside of the package and are used to connect the integrated circuit inside the package to external circuitry. The package of this invention not only allows flexibility in the functions of certain I/O terminals from the package but also allows a terminal originally designated as an I/O terminal to function as a ground or power terminal. The package of this invention also allows the provision of a capacitor as an inherent part of the package, between the power supply and the ground plane to filter out noise generated from any of a number of sources both internal and external to the package.

In accordance with this invention a plurality of conductive fingers of which a selected number are electrically insulated each from the other are formed inside the package on one or more planes of the package. Connected to many but not necessarily all of the fingers are a multiplicity of terminals (sometimes referred to and shown as pins) for use in making electrical contact to the integrated circuit placed inside the package. In one embodiment of this invention, the number of terminals is less than the number of fingers. Lead wires can be bonded from one finger to another finger connected directly or indirectly to a power plane, a ground plane or an I/O terminal to allow the one finger to be connected to the power terminal, ground terminal or the I/O terminal. This gives added flexibility to the package structure and allows a given package structure to be used with a number of different output pin assignments and for a number of different integrated circuits. In this sense the package is said to be "programmable".

In one embodiment of this invention each of the selected number of conductive fingers which are electrically insulated from each other are connected to a terminal from the package. The remaining fingers are either connected to the power plane in the package or to the ground plane in the package. Selected terminals from the package can be programmed to carry ground or power by connecting the fingers connected to these terminals to the ground or power planes in the package by means of lead wires, vias or other conductive means. The ground and power planes can be on the same level or different levels in the package and can include conductive protrusions extending among the fingers for ease of programming. The package is programmed by forming wire bonds or other connective means from selected protrusions from the ground and power planes to selected fingers.

The package of this invention can be made from a variety of materials including ceramic or plastic. In one embodiment the package makes use of printed circuit board technology to provide a ground plane on one side of the printed circuit board and a power plane on the other side. Thus the power plane is capacitively coupled to the ground plane through the printed circuit board dielectric to filter noise which may be generated on or off chip. The integrated circuit die is generally bonded to the ground plane and the power plane is accessible to the die by means of a via or vias through the printed circuit board dielectric. Each via terminates in a finger or bond pad which can then be connected to the die by means of wire bonding, tape automated bonding or other interconnect technology.

Other features and advantages of this invention will be apparent to those skilled in the art from the following detailed description taken together with the accompanying drawings.

## Description of the Drawings

Figure 1 illustrates an isometric view of a portion of a package of my invention which employs a dual plane structure;

Figure 2 illustrates a top view of a package of my invention which employs a single plane structure;

Figure 3 illustrates a cross-sectional view of a ceramic package structure employing the principles of my invention;

Figure 4 illustrates a structure wherein the die pad is electrically isolated from the power and ground buses;

Figures 5a and 5b illustrate the arrangement of the output terminals on a pin grid array package of the prior art;

Figure 6 illustrates a portion of a chip carrier embodiment of this invention; and

Figure 7 illustrates a prior art package with a semiconductor mounted on a ground plane and a plurality of conductive fingers attached to a corresponding plurality of package terminals for use in connecting the semiconductor to external circuitry.

## Detailed Description

While several embodiments of this invention will be illustrated, other embodiments of this invention will be obvious in view of the description contained herein. Thus, these descriptions are meant to be illustrative only and not limiting.

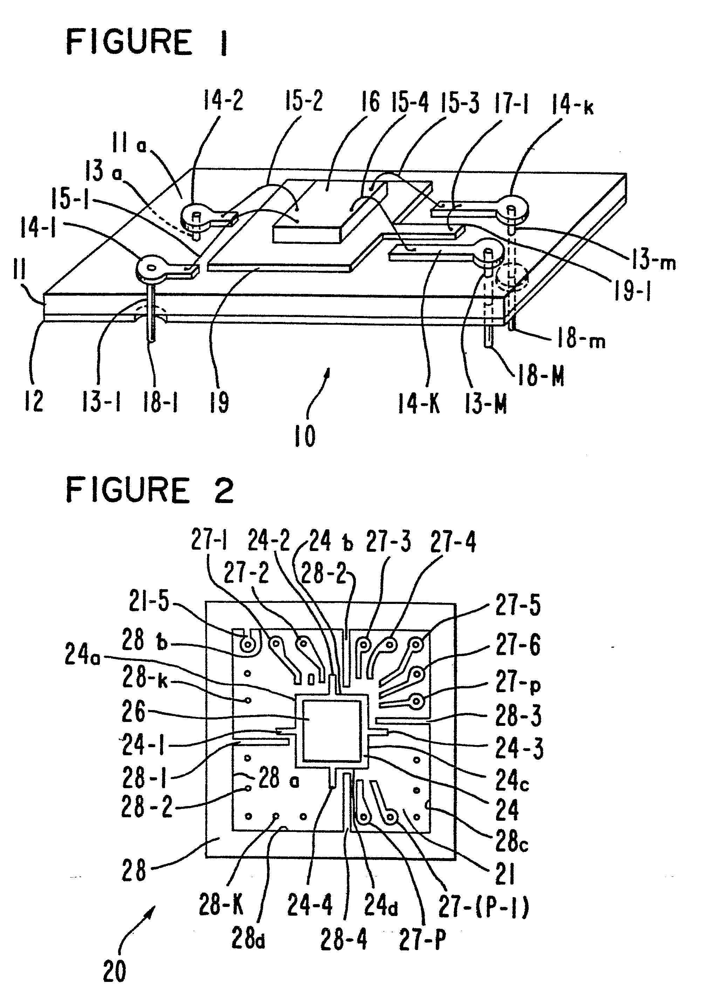

Figure 1 illustrates a portion of one embodiment of a package of this invention. In Figure 1 the package structure comprises a dielectric material 11, typically formed of a fiberglass-reinforced epoxy (for example, an epoxy of a type used in printed circuit boards) or any other appropriate dielectric material. Upon the bottom surface of dielectric 11 is formed a conductive plane 12. Typically conductive plane 12 is made of copper in a manner well known in the printed circuit board art. Protruding from the bottom of the printed circuit board 11 are a plurality of terminals or pins 18 denoted as pins 18-1 through ... 18-M where M is an integer representing the maximum number of I/O, power and ground pins used in the package and m is an integer given by $1 \leq m \leq$ M. Typically, four ground pins and four power pins, symmetrically arranged, are used in the package of this type. The use of four ground pins and four power pins allows these pins to be placed symmetrically on the package so that if the package is plugged into a socket in any one of the four possible ways, the proper pins will contact the ground and power supplies in the socket. The remaining terminals 18 provided in the package function as I/O terminals. To provide an operative structure, portions of conductive plane 12 surrounding each terminal 18-1 through 18-M (except the one or more terminals 18 connected to the power plane 12 as in terminal 18-M) are removed. This electrically isolates the terminals adjacent to the removed material from power plane 12.

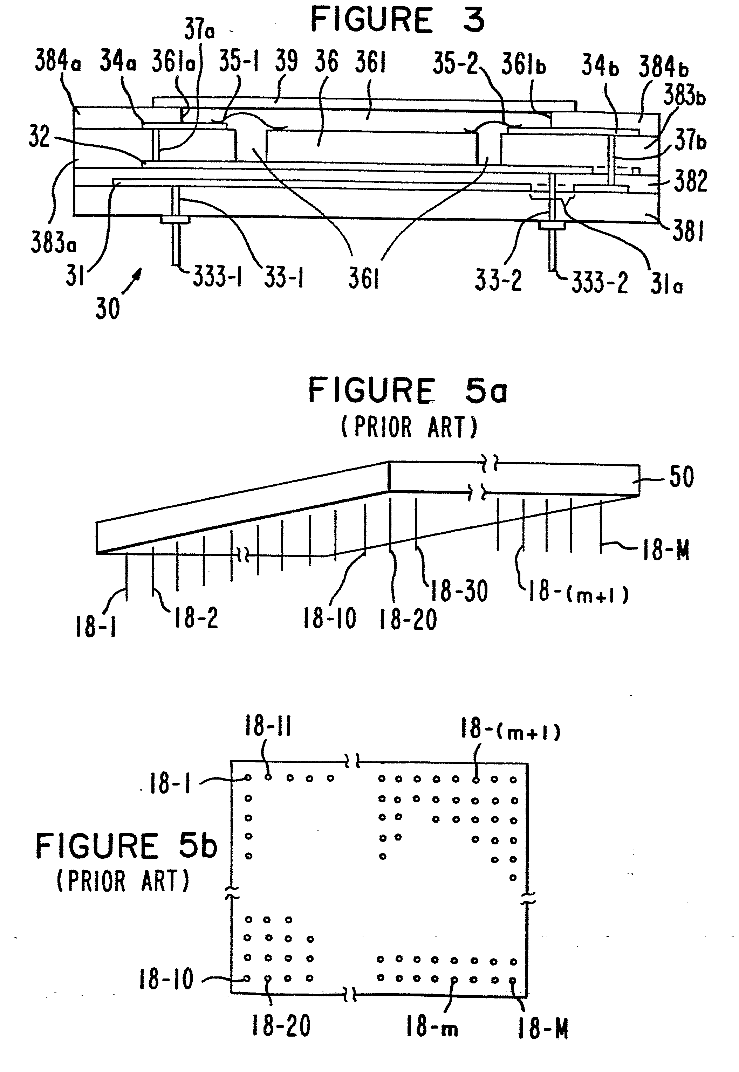

In a typical prior art pin array package, the pins protrude from one surface of the package in substantially uniform or symmetrical arrays. Such a structure is shown in Figures 5a and 5b. The package of Figures 5a and 5b shows a plurality of pins protruding from the bottom surface of the package. Thus in Figure 5a pins 18-1 through 18-M protrude from the bottom of the package 50 and are shown in Figure 5b to protrude over substantially the entire bottom of the package. This structure reflects the high density of terminals required to provide a functional package capable of handling the large number of I/O, power and ground pins required with today's VLSI integrated circuits. Returning now to Figure 1, the pins 18-1 through 18-M are shown to be connected by means of conductive vias (such as vias 13-1 through 13-M) through the dielectric 11 to the fingers 14-1, 14-2, ... 14-k through 14-K, where K is a selected integer representing the maximum number of fingers formed on the top surface of the dielectric 11 and k is an integer given by $1 \leq k \leq K$. All the terminals 18-1 through 18-M are electrically connected to one or more of the corresponding fingers 14. However, each finger 14 is not necessarily electrically connected directly to a corresponding terminal 18. In other words, in accordance with my invention there may be more fingers 14 than terminals 18. For example, in Figure 1 finger 14-2 is connected to power plane 12 through via 13a and not directly to a terminal 18. However finger 14-K is connected both to power plane 12 and directly to terminal 18-M. This gives the package of my invention the flexibility to allow it to be programmed to be used with a number of different integrated circuits or a number of different pin configurations. The programming comprises selecting which terminals 18 are to be connected to power or ground by appropriately wire bonding their associated conductive fingers 14 to the power plane 12 or to the ground plane 19.

Returning to Figure 1, via 13a is shown extending from power plane 12 through dielectric 11 into electrical contact with overlying finger 14-2. However, no pin or terminal is attached at the end of via 13a opposite finger 14-2 nor is a portion of conductive power plane 12 removed from around this end of via 13a. Thus via 13a is not electrically isolated from power plane 12. Rather, via 13a is electrically connected to plane 12 and thus conducts the power from plane 12 to finger 14-2. Terminal 18-M is shown as being electrically connected also to plane 12. This terminal will provide power from an external source to power plane 12. Naturally, a number of vias such as via 13a can be used in the package of my invention to allow power to be distributed to various locations around and on die 16. While only finger 14-2 is shown as not being connected to a pin 18, in an actual package constructed in accordance with the principles of my invention, a number of fingers such as finger 14-2 are provided not directly connected to a corresponding pin 18.  Indeed, if desired, a number of fingers 14 can be provided not connected even to vias such as via 13a or via 13-1.  Such fingers (which float electrically until connected to die 16 or other fingers 14) can then be connected by bonding wire to provide any appropriate function.

As shown in Figure 1 a die 16 is bonded on a ground plane 19 attached to the top surface 11a of dielectric 11.  Die 16 has lead wires (of which wires 15-1 through 15-4 are shown) attached from bonding pads (not shown) on die 16 to corresponding ones of fingers 14.  The lead wires 15 are formed in a well-known manner using well-known techniques.  The ground plane 19 has protruding from it at least one finger extension such as extension 19-1.  Extension 19-1 serves as a ground contact finger suitable for receipt of a wire bond.  Connecting bonding finger extension 19-1 to finger 14-k is lead wire 17-1. Thus terminal 18-m attached to finger 14-k is now defined to be a ground terminal.  If desired, ground plane 19 can be made larger and extensions such as extension 19-1 can be omitted.  Then lead wire 17-1 would be bonded directly to a selected portion of ground plane 19.  Lead wire 15-3 contacts a bonding pad on the top surface of die 16. This bonding pad functions as a ground pad on the chip.

The structure illustrated in Figure 1 has several novel features.  First, the number of fingers 14 and protrusions such as protrusion 19-1 are greater than the number of terminals 18.

Secondly, a selected number of terminals 18 can be used as power terminals (or ground terminals) merely by making the proper connection from a power finger 14-2 or 14-K (or ground protrusion 19-1) to the corresponding finger attached to the proper ones of output terminals 18-1 through 18-M.  For example terminal 18-1 can be made to be a power terminal at substantially the same potential as terminal 18-M by connecting one or more lead wires from finger 14-1 to finger 14-2. Finger 14-2 is connected by conductive via 13a to power plane 12 which is connected directly to power terminal 18-M. Each terminal 18 can be assigned to any one of a number of functions depending upon the location of the bonding pads to which these functions are assigned on the semiconductor chip 16. Thus the package allows great flexibility in determining which terminals 18 are to be connected to ground, power supply and I/O functions. In other words, the various pins and terminals on the package can be personalized or programmed to the needs of the integrated circuit die to be mounted in the package. This allows one package to be used for a plurality of different dice and/or terminal assignments. The flexibility in packaging achieved using this package significantly reduces the different number of packages that must be carried in inventory and thus reduces manufacturing costs. Custom integrated circuits (and particularly gate arrays) can now be manufactured using a standard package configuration wherein the package terminals are personalized to the needs of the particular custom chip to be mounted in the package. Thus the package of Figure 1, having more bonding fingers 14 and protrusions 19-1 internally than external terminals 18, allows the particular terminals to which leads from the die are to be bonded to be personalized to the needs of the chip and/or application.

Third, an internal capacitor between the ground and power planes, when present, will filter circuit noise in the power supply.

Figure 2 illustrates another embodiment of this invention in which the package of this invention has the power supply and ground buses as well as the I/O fingers all formed in the same plane within the package. Figure 2 illustrates the top plan view of this structure. In the structure of Figure 2, the package 20 has a layer of conductive material formed on a dielectric 21.  The conductive material is then patterned using standard well-known masking and etching techniques to form a power bus 28 partially or completely surrounding the interior region 21 of the dielectric surface.  Protrusions 28-1, 28-2, 28-3 and 28-4 protrude inwardly toward the conductive ground plane 24 (also formed from the same conductive material) from each of the four internal surfaces 28a, 28b, 28c and 28d of the conductive band 28.  Conductive band 28 serves as a power bus.  Conductive protrusions 28-1 through 28-4 from bus 28 provide structure to be contacted by wires which are also connected to the power pad or pads on die 26 mounted on ground pad 24.  If conductive band 28 is the power supply bus, conductive protrusions 28-1 through 28-4 provide a source of power supply for use on different regions of the chip 26.  Power bus 28 is connected to a terminal protruding from the bottom (not shown) of the package which is connected to protrusion 21-5, for example.  In this embodiment, protrusion 21-5 is intended to represent a permanent electrical attachment from one of the package terminals to the power bus 28.

Ground plane 24 is also formed from the same conductive material formed on dielectric 21 as is conductive bus 28.  Ground plane 24 contains protrusions 24-1 through 24-4 protruding from the four sides 24a through 24d of the ground plane 24.  Of course, other protrusions could also extend from ground plane 24 and both ground plane 24 and conductive bus 28 could be formed of other than a square or rectangular shape as desired.

Conductive protrusions 24-1 through 24-4 provide contact points for making contact by means of bonding wires from the ground terminal(s) to the ground plane on which die 26 is mounted and to the ground bonding pads (not shown) on the die 26.

Conductive fingers 27-1, 27-2, ... 27-p through 27-P (where P is a selected integer and where p is an integer given by $1 \leq p \leq P$) are formed also by masking and etching techniques from the same material as used to form bus 28 and ground plane 24. Fingers 27-1 through 27-P can be connected by means of lead wires to pads (not shown) on die 26 or to other ones of fingers 27 or even to protrusions 28-1 through 28-4 or 24-1 through 24-4 depending upon how each finger is to function. Fingers 27 each may be connected to a pin (such as pins 18-1 through 18-M as shown in Figures 5a and 5b) protruding from the bottom side of the package. Fingers not connected to pins (i.e., terminals) can be connected to other fingers which are attached to pins or by means of vias to the ground bus or to the power supply bus. Thus, great flexibility is achieved in the design of this package through the use of a plurality of fingers 27.

An additional embodiment of this invention is illustrated in Figure 3. In Figure 3 a ceramic structure is shown wherein a conductive plane 31 (typically formed of a refractory metal such as tungsten) is formed on a substrate 381, typically ceramic such as $Al_2O_3$, and another conductive plane 32 is formed on another layer of dielectric material 382 formed over conductive plane 31 which functions as the power plane. The second layer of dielectric material 382 is typically formed of a ceramic over the first conductive layer 31. An opening 31a is provided in conductive layer 31 to allow via 33-2 to be formed through both first ceramic layer 381 and second ceramic layer 382 to contact second conductive layer 32. A pin 333-2 is mounted on the bottom of via 33-2 to allow electrical connection to be made from an external reference through pin 333-2 and the conductive material in via 33-2 to the conductive plane 32. A third layer of ceramic material 383 is directly above ceramic material 382 and conductive layer 32. Additional via 37b is formed through portion 383b of ceramic material 383 to conductive region or finger 34b formed in a layer 34 of conductive material on top of ceramic material 383b. Via 37b allows electrical contact to be made from conductive plane 31 to conductive plane 34b. A lead wire 35-2 is then attached to a semiconductor die 36 placed in a cavity 361 in the ceramic material 383 exposing conductive plane 32. Thus conductive plane 32 functions as a ground plane to which die 36 is bonded. Contact from conductive plane 32 to third level conductive plane 34a is made through via 37a formed through ceramic material 383a. Lead wire 35-1 connects ground plane 32 through finger 34a (which is electrically isolated from conductive plane 34b) to the ground pad on die 36. The top portion of cavity 361 has an outer extremity laterally defined by walls 361a and 361b (shown in cross-section.)

The package in which die 36 is bonded possesses a number of different conductive planes; a ground plane 32 on which the die 36 is bonded, a conductive plane 31 insulated from the ground plane by ceramic material 382 and a plane 34 on top of ceramic material 384b, 384a from which conductive fingers 34a, 34b are formed and to which lead wires 35-1, 35-2 are bonded to make contact with bonding pads on top of die 36.

An additional layer of ceramic 384a, 384b overlies ceramic 383a and 383b to form an upper portion of the chip cavity, the edges of which are denoted 361a and 361b. Finally a lid 39 is sealed over the top of the cavity 361 to protect the semiconductor die 36 and lead wires 35 bonded inside the cavity. Again, the structure shown in Figure 3 makes use of a number of fingers (such as the fingers 34a and 34b to which lead wires 35-1 and 35-2 are bonded) connected by means of vias such as vias 37a and 37b to the ground plane 32 or the power plane 31. Thus via 37b connects the power plane 31 to conductive finger 34b while via 37a connects the ground plane 32 to finger 34a.

Figure 6 illustrates a portion of an embodiment of this invention comprising a chip carrier 60. A chip carrier is a structure which has bonding fingers 63-1 to 63-M extending to terminals 64-1 to 64-M on all four sides of the package where M is a selected integer equal to the maximum number of fingers to be formed in the package and m is an integer given by $1 \leq m \leq M$. Terminals 64 are often wrapped around the edges of the package dielectric layer 61 to the package surface opposite and parallel to the surface to which the die 66 is bonded. This provides a bonding surface on a second level of the package and allows the package to be bonded on its second surface directly to a printed circuit board of which the package is to be a part. Of course, the structure of Figure 6 can also be mounted upside down on a socket with the die 66 and lead wires 65 protected by a cavity in the socket below the contact plane. In the structure of Figure 6, dielectric 61 has formed on it a plurality of conductive fingers 63-1, 63-2 ... 63-m through 63-M. A die 66 is mounted on a ground plane 70 formed on the top surface of dielectric 61. The ground plane 70 has protrusions 70-1 and 70-2 extending from it to which lead wires 67-1 and 67-2 are bonded. Wire 67-1 provides a ground potential to the die 66 while wire 67-2 interconnects the ground plane to finger 63-M. Thus finger 63-M will be at ground potential. In addition, a second type of finger 68-1 and 68-2 is shown in Figure 6. This second type of finger comprises the power fingers in this structure. Vias 71-1 and 71-2 connect these fingers through the dielectric 61 of the printed circuit board to the power plane 62 on the bottom surface of dielectric 61. The electrically conductive path formed by bonding wire 67-1 from power finger 68-2 to package terminal 64-2 define terminal 64-2 and finger 63-2 as the power terminal and finger through which power is provided to the integrated circuit 66.

Bond wires 65-1 through 65-N (where N is a selected integer and n is an integer given by 1 ≤ n ≤ N) are shown extending from pads (not shown) on die 66 to fingers 63-1, 63-2, ... 63-m ... 63-M. Lead wire 65-N for example extends from a bond pad on the die 66 to power finger 68-1 while lead wire 67-1 extends from power finger 68-2 to finger 63-2 thus defining finger 63-2 to be the power supply finger and terminal 64-2 to be the power supply terminal. Wire 65-2 extends from finger 63-2 to a pad on die 66 thus allowing power to be brought from finger 63-2 to both the die 66 and to power finger 68-2. A via 71-2 extends from power finger 68-2 through dielectric 61 to make conductive contact with conductive layer 62 on the second side of dielectric 61. Layer 62 thus becomes the power bus and power can be brought back through dielectric 61 from conductive layer 62 to other fingers such as finger 68-1 on the first surface of dielectric 61. Wires, such as wire 65-N, can then be bonded from these additional fingers 63 to bonding pads (not shown) on die 66. Thus power can be distributed to different portions of integrated circuit chip 66 without using as many buses or as large an area on the surface of the chip as heretofore.

Lead wire 65-1 extends from finger 63-1 to a pad on the die 66. Lead wire 69 extends from ground plane protrusion 70-1 to a pad on the die 66.

On the bottom side of dielectric 61 is formed a conductive power layer 62. The dielectric 61 between conductive power layer 62 and ground layer 70 allows layers 62 and 70 to form a capacitor. Noise is shunted from the power lead 62 to ground 70 by means of this capacitor. Thus the package of this invention as shown in Figure 6 is inherently immune to most noise of concern. Power fingers 68-1 and 68-2 are connected to power layer 62 by vias 71-1 and 71-2.

In the structure of Figure 6, fingers 63-1 through 63-M extend to the edge of the dielectric 61 and there form terminals 64-1 through 64-M. Openings or grooves are provided in the edge of dielectric 61 adjacent the terminus of each finger 63 such that the dielectric 61 can actually be plated-through at these openings with conductive material to form terminals 64-1 through 64-M. The contacts to fingers 63 are then formed on the bottom side of dielectric 61 in a manner well-known in the art. Typically circuit contacts are made to the package terminals 64-1 through 64-M either by soldering the chip carrier to traces on a printed circuit board or by placing it in a socket, either right side up or, as described above, upside down.

The structure 40 of Figure 4 illustrates still another embodiment of this invention. In the structure 40 of Figure 4 a printed circuit board 41 has formed on it a conductive band 48 which can function either as the power or ground band and an additional conductive band 44 which can function as either the ground or the power band. A die 46 is mounted on a conductive material 444 placed within but electrically insulated from conductive band 44. If desired, material 444 can be nonconductive.

Conductive fingers 47-1 through 47-5 are shown formed on one portion of the dielectric 41. Of course, numerous other fingers are formed in the package in addition to the limited number of fingers shown. It should be noted that fingers 47 are formed in two rows. The odd numbered fingers 47-1, 47-3, 47-5, etc. in this illustration are formed to make contact to an outer row of pins (not shown) on the back side of dielectric 41 while the even numbered fingers 47-2, 47-4, etc. are formed to make contact to an inner row of pins (not shown) on the backside of dielectric 41. Thus, a dual row of pins is provided surrounding all four edges of this package. Of course, if desired a plurality of rows of fingers could be provided to contact a plurality of rows of pins extending from the bottom surface of dielectric 41. Fingers 47-1 through 47-5 are shown wire bonded to bonding pads on die 46 by means of leads 45-1 through 45-5. Lead 45-6 extends from die 46 to conductive protrusion 48-3 protruding from one edge of conductive ring 48. Typically, if conductive ring 48 is the power supply, protrusion 48-3 will provide power through conductive wire 45-6 to die 46. If ring 48 is ground, then lead 45-6 will serve as a ground lead to the pad on the chip to which it is connected. Ring 44 has conductive lead 45-7 bonded from a pad on the surface of chip 46 to it. Ring 44 will be either ground or power supply as desired.

A significant advantage of the package configuration illustrated in Figure 4 is that power can be supplied to the chip from multiple points around the periphery of chip 46 thus reducing the size of the power and ground buses on chip 46 and thus reducing chip size. This is a significant advantage resulting from the use of multiple power and ground locations without requiring the commitment of a package terminal for each additional location.

The structures shown in Figures 1, 2, 4 and 6 can be closed in any one of a number of ways. For example, a blob seal can be used or various domed package covers or similar lids of a type well-known in the art can be employed to close and protect the chips and lead wires from mechanical damage.

Moreover, throughout this specification and claims, the phrases a "dielectric layer" and a "conductive layer" shall be understood to refer to one or more layers of dielectric or conductive material, respectively.

Other embodiments of this invention will be obvious in view of this disclosure to those skilled in the packaging arts. While the package of this invention has been described as a package for semiconductor devices, this package is suitable for use with other electronic devices, such as passive resistor networks and hybrid circuits.

The figures used in the claims are only meant to explain more clearly the intention of the invention and are not supposed to be any restriction concerning the interpretation of the invention.

-1-

CLAIMS:

What is claimed is:

1. A package for electronic devices comprising a layer of insulating material containing a first surface on one side of said layer and a second surface on the other side of said layer opposite and parallel to said one side; and a first layer of conductive material formed on said first surface; said structure being characterized by including:

a second layer of conductive material formed on said second surface, said first and second layers of conductive materials providing conductive paths to ground and power connections within said package, said second layer of conductive material being adapted to have an electronic device mounted thereon;

a plurality of conductive fingers formed from said second layer of conductive material;

a multiplicity of vias formed through said insulating material from selected ones of said conductive fingers to openings in the first layer of conductive material; and

a multiplicity of terminals formed on said first surface to extend away from the first surface of said insulating material, said terminals being electrically connected to said multiplicity of vias so as to form electrical connections to said selected ones of said conductive fingers, the number of terminals being less than the number of fingers formed in the opposite surface of said dielectric and all but a selected number of said terminals being insulated from said first layer of conductive material.

2. The package as in Claim 1 further characterized in that a given number of said multiplicity of terminals is formed in electrically conductive contact with conductive material formed in a corresponding number of vias through said insulating material.

3. The package as in Claim 2 further characterized in that a portion of said first layer of conductive material surrounding said selected number of terminals is removed, thereby to electrically isolate each of said selected number of terminals from said first layer.

4. The package as in Claim 3 further characterized in that said given number of terminals is in electrically conductive contact with said first layer of conductive material.

5. A semiconductor package comprising a substrate of insulating material on which an electronic device is mounted, leaving exposed portions of said insulating material adjacent said device, characterized by including

a plurality of conductive fingers formed on said exposed portions of said insulating material, each conductive finger being laterally spaced from each of the other conductive fingers,

a number of conductive terminals suitable for electrically connecting said package to external circuitry, said conductive terminals being formed on said substrate,

**0162521**

and

       means for interconnecting said number of conductive
terminals to a selected number of said plurality of
conductive fingers, said selected number being less than
the total number of said plurality of conductive fingers.


6.    Structure as in Claim 5 further characterized in
that said conductive terminals are formed on the opposite
side of said substrate from the side on which said die is
mounted, and said means for interconnecting comprises
       a multiplicity of conductive vias formed through
said insulating material to make conductive contact to
selected ones of said conductive fingers.


7.    Structure as in Claim 6 further characterized by
including means for conductively connecting to others of
said fingers one or more of said fingers not connected
through vias to terminals.


8.    Structure as in Claim 7 further characterized in
that said means for connecting comprises an electrically
conductive plane in contact through a via with said one
or more fingers not connected through vias to terminals,
said conductive plane connecting said one or more fingers
to a terminal adapted to be connected to an external
power supply or ground.


9.    Structure as in Claim 5 further characterized in
that said electronic device comprises an integrated
circuit die.

# FIGURE 1

# FIGURE 2

0162521

## FIGURE 3

## FIGURE 5a
(PRIOR ART)

## FIGURE 5b
(PRIOR ART)

# FIGURE 6

65-3 70-1 65-4 65-6 63-m
63-2 67-1 65-2 64-3 64 65-5 61 64-m
64-2
68-2
71-2
64-1
63-(m+1)
64-(m+1)
68-1
71-1 64-m
63-1 65-1 62 69 70 65-N 70-2 67-2 63-M
66
60

# FIGURE 7
## (PRIOR ART)

75-15 76-15 73
74a
75-18
76-18
78-15 77a
76-1
78-18 72 78-1 75-1
77b 78-40 75-40
76-40
74b

FIGURE 4